# EUROPEAN PATENT SPECIFICATION

(11) **EP 4 171 185 B1**
(45) Date of publication and mention of the grant of the patent: **20.08.2025**
(21) Application number: 22202611.4
(22) Date of filing: 19.10.2022
(51) Int. Cl.: H05K 5/06, H05K 7/20

(54) **SEAL FOR THERMAL INTERFACE MATERIAL OF POWER ELECTRONICS MODULES**
DICHTUNG FÜR THERMISCHES GRENZFLÄCHENMATERIAL VON LEISTUNGSELEKTRONIKMODULEN
JOINT D'ÉTANCHÉITÉ POUR MATÉRIAU D'INTERFACE THERMIQUE DE MODULES ÉLECTRONIQUES DE PUISSANCE

(30) Priority: 22.10.2021 US 202163270888 P
(43) Date of publication of application: 26.04.2023
(73) Proprietor: Carrier Corporation, Palm Beach Gardens, FL 33418 (US)
(72) Inventor: BORISOV, Konstantin, Bloomfield, 06002 (US); SLAY, William Tony, Charlotte, 28269 (US); AGIRMAN, Ismail, Bloomfield, 06002 (US)
(74) Representative: Dehns

(56) References cited:
- JP-A- 2010 092 999
- US-A1- 2016 240 456
- US-B1- 8 077 460
- US-B2- 7 369 411

## Description

The present invention relates to a heat exchange assembly. Exemplary embodiments pertain to the art of heat exchangers, and particularly to an interface for cooling power electronics that are mounted to a heat exchanger.

Power electronic devices such as motor drives can generate waste heat during operation based on the efficiency of the device. Additionally, when the power electronic devices heat up, their efficiency can degrade adding to the amount of heat they generate. When configured into a refrigeration system, effective thermal integration of these devices can be important aspect to the system's overall efficiency and reliability. Consequently, a goal of the system integrator is to maintain these components within a range of operating temperatures which will maximize the system efficiency. Accordingly, there remains a need in the art for heat exchangers configured to closely integrate with power electronic devices which can maintain optimal temperatures for these components under a variety of load conditions.

JP 2010 092999 A and US 2016/240456 A1 each disclose electronic devices provided in combination with heat dissipation devices. The electronic devices are mounted to a base structure, this base structure being mounted to the heat dissipation device by grease. A sealing or retaining member can be provided to prevent outflow of the grease. Further prior art is disclosed in US7369411B2.

Viewed from a first aspect, there is provided a heat exchanger assembly as claimed in claim 1.

The gasket may extend about at least a portion of a periphery of the heat sink interface.

The gasket may extend about an entire periphery of the heat sink interface.

The gasket may be compressed to form a seal between the heat sink interface and the surface of the housing of the heat exchanger.

The surface of the heat exchanger may have a substantially planar configuration and the gasket is positioned in overlapping arrangement with the surface.

Only a portion of the gasket may extend beyond the surface of the heat exchanger.

The gasket may have a substantially continuous tube-like configuration.

The gasket may have a substantially planar configuration.

The thermal interface material may be thermal grease.

The heat exchanger may comprise: the housing, wherein said housing has an inlet and an outlet formed therein; a fluid circuit arranged within the housing and extending between the inlet and the outlet; and a fluid circulating through the fluid circuit.

The fluid circuit may comprise: an inlet manifold; an outlet manifold; and a plurality of fluid passages connecting the inlet manifold and the outlet manifold.

At least one of the inlet manifold, the outlet manifold, and the plurality of fluid passages may be formed as a recess formed in the housing.

The inlet may be disposed below the outlet such that during operation a flow direction of a refrigerant through the inlet manifold and the outlet manifold opposes gravity.

The housing may comprise a first housing portion and a second housing portion joined along corresponding mating surfaces.

The first housing portion and the second housing portion may be a plate.

The following descriptions should not be considered limiting in any way. With reference to the accompanying drawings, like elements are numbered alike:
FIG. 1 is a schematic illustration of an exemplary heat exchanger having a power electronic modules mounted thereto;
FIG. 2 is a schematic illustrations of the A-A cross section of the heat exchanger of FIG. 1;
FIG. 3 is a front view of an exemplary heat exchanger having a plurality to of power electronic modules mounted thereto;
FIG. 4 is a cross-sectional view of a portion of the heat exchanger of FIG. 3 taken through a power electronic module not in accordance with the present invention; and
FIG. 5 is a cross-sectional view of a portion of the heat exchanger of FIG. 3 taken through a power electronic module.

A detailed description of one or more embodiments of the disclosed apparatus and method are presented herein by way of exemplification and not limitation with reference to the Figures.

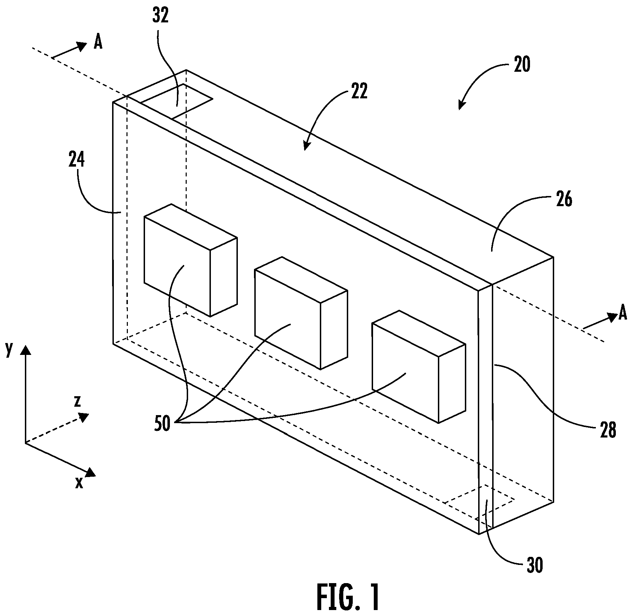

With reference now to Figure 1, a schematic illustration of an example of a heat exchanger 20 is illustrated according to an embodiment. As shown, the heat exchanger 20 includes a housing 22 formed from a heat conductive material, such as a metal material. For example, the housing 22 may be formed from any suitable metal, e.g., aluminum, aluminum alloy, steel, steel alloy, copper, copper alloy, or the like. In the illustrated, non-limiting embodiment, the housing 22 is formed from a plurality of housing portions, such as a first housing portion 24, and a second housing portion 26, joined along corresponding mating surfaces to form a seam 28 therebetween. In such embodiments, the first and second housing portions 24, 26 can abut one another along a side and can be joined using any suitable means such as brazing, welding, clamping, compressing, bolting, and the like. Although two housing portions 24, 26 are illustrated in the exemplary embodiments, it should be understood that a housing 22 formed from any number of housing portions including a single housing portion, or more than two housing portions for example, are contemplated.

The mating surfaces of the first and second housing portions 24, 26 may be configured to correspond to one another, e.g., to fit together to seal a fluid circuit therebetween (the fluid circuit to be described in more detail below). In an embodiment, the mating surfaces of the first and second housing portions 24, 26 include precision surfaces formed from a process having highly accurate and precise dimensional control, such as through computer numerical control (CNC) machining process and/or net shape, or near net shape manufacturing process. Optionally a sealing material can be disposed between the first and second housing portions 24, 26 to aide in preventing leakage from the fluid circuit.

As shown in Fig. 1, the first and second housing portions 24, 26 can have different thicknesses, measured along the z-axis. In the illustrated, non-limiting embodiment, a thickness of the first housing portion 24 is greater than a thickness of the second housing portion. However, embodiments where the first housing portion 24 and the second housing portion 26 are equal in thickness, or alternatively, where a thickness of the second housing portion 26 is greater than a thickness of the first housing portion 24 are also contemplated. In an embodiment, each of the first housing portion 24 and the second housing portion 26 is formed as a substantially solid plate. However, embodiments where one or more of the housing portions 24, 26 has another configuration are also contemplated herein.

The heat exchanger 20 includes a fluid circuit formed between the first and second housing portions 24, 26. The fluid circuit includes a fluid inlet 30 and fluid outlet 32 formed in the housing 22. The fluid inlet 30 and the fluid outlet 32 can be any shape, such as in the depth dimension (e.g., in the z-x plane of the attached figure), including the shape of a circle, oval, triangular, square, rectangular, or any simple polygonal shape or portion thereof. Further, the perimeter of one or both of the fluid inlet 30 and the fluid outlet 32 can be formed by a recess in at least one or both of the housing portions 24, 26. The recess may extend to an edge of a respective housing portion, may be arranged centrally relative to a housing portion, or may overlap with the seam 28 defined between two adjacent housing portions 24, 26.

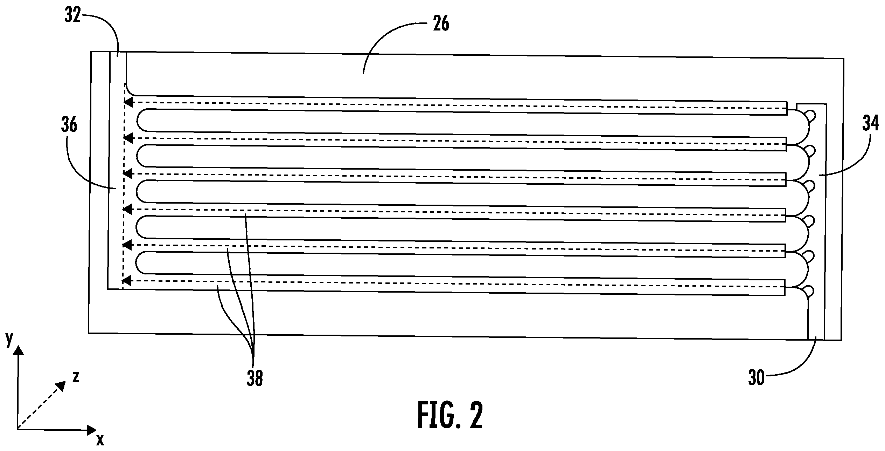

An example of the fluid circuit is best illustrated in the cross-sectional view of the heat exchanger 20 shown in FIG. 2. In addition to the inlet 30 and the outlet 32, the fluid circuit may include a first or inlet manifold 34, a second or outlet manifold 36, and a plurality of fluid passages 38 connecting the first and second manifolds 34, 36. The fluid inlet 30 can be configured to connect a first heat transfer fluid (e.g., refrigerant) source, such as a condenser of a vapor compression system for example, to the inlet manifold using any suitable mechanical connection. Similarly, the fluid outlet 32 can be configured to connect a first heat transfer fluid sink, such as an evaporator of a vapor compression system for example, to the outlet manifold using any suitable mechanical connection (e.g., compression coupling, brazing, welding, and the like). In an embodiment, the fluid inlet 30 is disposed vertically below the fluid outlet 32 such that during operation of the heat exchanger 20, a flow direction of a refrigerant through the inlet and outlet manifolds 34, 36 opposes gravity.

One or more of the inlet manifold 34, the outlet manifold 36, and the plurality of fluid passages 38 is formed as a recess in at least one of the first housing portion 24 and the second housing portion 26. In an embodiment, the inlet manifold 34, the outlet manifold 36, and the plurality of fluid passages 38 are formed as a plurality of connected recesses in at least one housing portion, such as the second housing portion 26 for example. Accordingly, the plurality of recesses form the fluid circuit disposed between the first and second housing portions 24, 26 when the housing portions 24, 26 are joined. For example, a first housing portion 24 having a plurality of connected recesses can be joined to a flat, second housing portion 26 that does not have any recesses formed therein. In another embodiment, a first housing portion 24 and a second housing portion 26 can each have a plurality of connected recesses which mirror one another such that when the first and second housing portions 24, 26 are joined, the connected recesses form the fluid circuit. The plurality of connected recesses can have any shape in the depth dimension (e.g., as projected onto a z-y plane of the attached figures, into the plate), including semi-circular, semi-oval, triangular, square, rectangular, or any simple polygonal shape or portion thereof.

The mating surfaces of the first and second housing portions 24, 26 can substantially border the plurality of connected recesses. Optionally, the mating surfaces can include raised or recessed portions, or other engagement features to aid in alignment of the housing portions 24, 26 prior to joining.

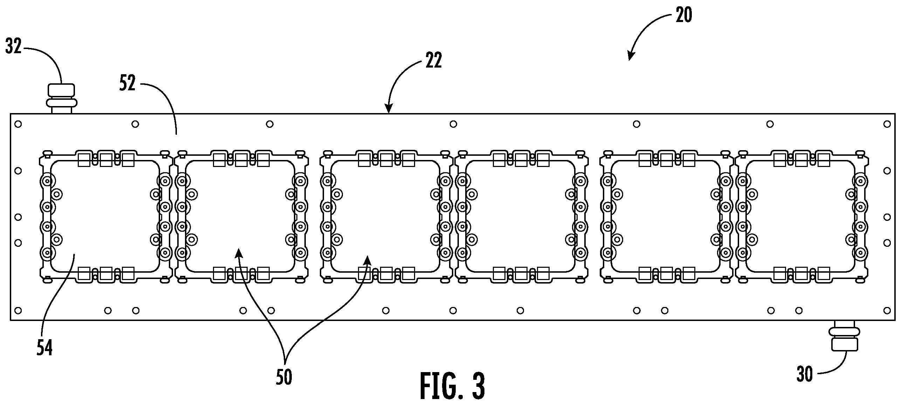

A heat exchanger 20 as described herein can be used, such as in a vapor compression system for example, to cool one or more power electronic modules 50. As described herein, a heat exchanger 20 having one or more power electronics modules 50 mounted thereon may be considered a heat exchanger assembly. The term "power electronic module" as used herein can refer to any electronic component which can provide a controlled output power by modulating and/or converting a supplied input power (e.g., a variable frequency drive, power rectifier, power converter, and the like). Such a power electronic module 50 can be used to control the speed of a compressor and/or the speed of the fan of a vapor compression system (e.g., chiller) based on various predetermined system conditions. With reference again to FIG. 1, and further reference to FIGS. 3-5, one or more power electronic modules 50 are mounted directly to a surface 52 of at least one of the plurality of housing portions, such as first housing portion 24 for example. According to the invention, the plurality of power electronics modules 50 are mounted to a vertically oriented surface of the housing 22. However, embodiments not covered by the present invention, where one or more power electronics modules 50 are mounted to a surface of a housing 22 having a non-vertical orientation, such as a horizontal surface for example, are also contemplated. The power electronic modules 50 may be mounted to the housing 22 of the heat exchanger 20 via one or more fasteners in such a way that facilitates the transfer of thermal energy away from the power electronics module 50.

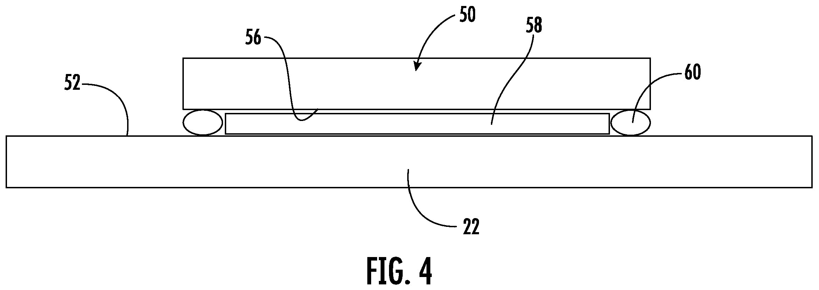

The one or more power electronics modules 50 may include a printed circuit board 54 on which various other electrical components (not shown) are mounted (e.g., protection, signal processing, and filtering related components). The reliability and life of the one or more power electronics modules 50 can depend upon precluding such electrical components from operating at high temperatures and/or precluding their exposure to thermal shock. Because electrical components inside the power electronics modules 50 can generate a large amount of heat, each of the power electronics modules 50 has a heat sink interface 56 (see FIG. 4) which is designed for attachment to a heat sink, such as the heat exchanger 20. When the power electronics modules 50 are secured in thermal communication with the heat exchanger 20, the heat generated by the power electronics module 50 is at least partially removed through the heat sink interface 56 to keep the one or more power electronics module 50 cooled below its maximum allowable operating temperature (e.g., 150 °C).

A thermal interface material, illustrated schematically at 58, may be positioned between the heat sink interface 56 of a respective power electronics module 50 and the adjacent surface 52 of the housing 22 configured to receive the power electronics module 50. In an embodiment, the thermal interface material 58 is a thermal grease or compound having a high thermal conductivity. However, in other embodiments the thermal interface material may include a multiphase material and/or an elastomeric material such as a thermal pad. In applications where a power electronics module 50 is mounted in a vertical plane relative to a surface 52 of the housing 22 of the heat exchanger 20, the gravitational forces acting on the thermal grease 58 may cause the thermal grease 58 to move or drip relative to the heat sink interface 56. In addition, if condensation collects on the surface 52 of the heat exchanger 20, such as resulting from the heat removal therefrom, the condensation in combination with the gravitational forces may wash the thermal grease 58 away from the heat sink interface 56.

In an embodiment, to prevent this loss or washing away of the thermal interface material 58 at the heat sink interface 56, a gasket 60 is disposed between a portion of the power electronics module 50 and the heat exchanger 20. The gasket 60 may extend about at least a portion of the perimeter of the power electronics module 50 at the heat sink interface 56. In the illustrated, non-limiting embodiment, the gasket 60 extends about an entire periphery of the heat sink interface 56. In such embodiments, the dimensions of the gasket 60 are substantially complementary to, or slightly smaller than, the length and width of a respective power electronics module 50. The gasket 60 may have a substantially continuous tube-like configuration, or alternatively, may have a substantially planar configuration similar to a washer. However, any suitable configuration of a gasket 60 is contemplated.

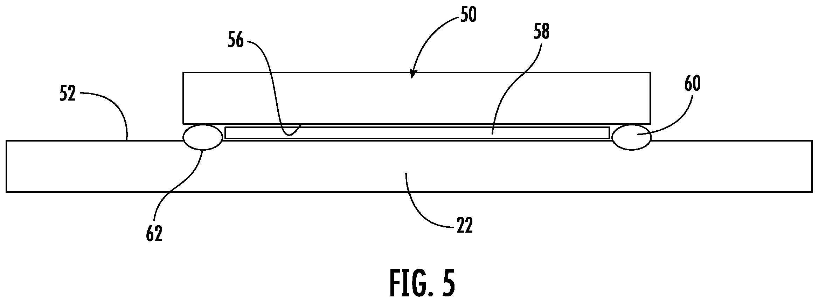

In an example not in accordance with the present invention, the surface 52 of the heat exchanger 20 configured to receive the power electronics module 50 is generally planar (see FIG. 4). As a result, the entirety of the gasket 60 is positioned adjacent to and in overlapping arrangement with the surface 52. In an embodiment in accordance with the present invention, best shown in FIG. 5, a gasket groove or recess 62 complementary to the gasket 60 is formed in the surface 52 of the heat exchanger 20. The gasket 60 is receivable within the gasket groove 62, and therefore in such embodiments only a portion of the gasket 60 may protrude beyond the surface 52 towards the power electronics module 50.

When the power electronics module 50 is installed about the surface 52 of the heat exchanger 20, the gasket 60 may be at least partially compressed, thereby forming a seal between the surface 52 of the heat exchanger 20 and a surface of the power electronics module 50 at the heat sink interface 56. Because the gasket 60 extends about at least a portion of the periphery of the heat sink interface 56, the gasket forms a boundary or outer edge to at least a portion of the thermal interface material 58. Accordingly, the seal formed between the power electronics module 50 and the surface 52 of the heat exchanger 20 by the compressed gaskets 60 forms a boundary that restricts movement of the thermal interface material 58 from adjacent to the heat sink interface 56.

By using a gasket to retain the thermal interface material 58 between the heat sink interface 56 of a power electronics module 50 and a heat exchanger 20, the thermal conductivity between the power electronics module 50 and the heat exchanger 20 is improved, thereby extending the life of the electronic components within the power electronics modules 50.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the scope of the claims. Therefore, it is intended that the present invention not be limited to the particular embodiment disclosed as the best mode contemplated for carrying out this present invention, but that the present invention will include all embodiments falling within the scope of the claims.

## Claims

1. A heat exchanger assembly comprising:
a heat exchanger (20) including a housing (22);
a power electronics module (50) mounted to a surface (52) of the housing (22) of the heat exchanger (20), wherein the power electronics module (50) is thermally coupled to the heat exchanger (20) at a heat sink interface (56);
a thermal interface material (58) arranged between the heat sink interface (56) and the surface (52) of the housing (22) of the heat exchanger (20); and
a gasket (60) arranged between the heat sink interface (56) and the surface (52) of the housing (22) of the heat exchanger (20);
wherein the power electronics module (50) is mounted to a vertically oriented surface (52) of the housing (22);
wherein the gasket (60) surrounds at least a portion of the thermal interface material (58); and
wherein the gasket (60) defines a boundary that restricts movement of the thermal interface material (58) relative to the heat sink interface (56) and the surface (52) of the housing (22) of the heat exchanger (20);
**characterized in that**:
the surface (52) of the heat exchanger (20) has a gasket groove (62) formed therein, the gasket (60) being arranged within the gasket groove (62).

2. The heat exchanger assembly of claim 1, wherein the gasket (60) extends about at least a portion of a periphery of the heat sink interface (56).

3. The heat exchanger assembly of claim 2, wherein the gasket (60) extends about an entire periphery of the heat sink interface (56).

4. The heat exchanger assembly of any preceding claim, wherein the gasket (60) is compressed to form a seal between the heat sink interface (56) and the surface (52) of the housing (22) of the heat exchanger (20).

5. The heat exchanger assembly of any preceding claim, wherein only a portion of the gasket (20) extends beyond the surface (52) of the heat exchanger (20).

6. The heat exchanger assembly of any preceding claim, wherein the gasket (60) has a substantially continuous tube-like configuration.

7. The heat exchanger of any of claims 1 to 5, wherein the gasket (60) has a substantially planar configuration.

8. The heat exchanger assembly of any preceding claim, wherein the thermal interface material (58) is thermal grease.

9. The heat exchanger assembly of any preceding claim, wherein the heat exchanger (20) comprises:
the housing (22), wherein said housing (22) has an inlet (30) and an outlet (32) formed therein;
a fluid circuit arranged within the housing (22) and extending between the inlet (30) and the outlet (32); and
a fluid circulating through the fluid circuit.

10. The heat exchanger assembly of claim 9, wherein the fluid circuit further comprises:
an inlet manifold (34);
an outlet manifold (36); and
a plurality of fluid passages (38) connecting the inlet manifold (34) and the outlet manifold (36).

11. The heat exchanger assembly of claim 10, wherein at least one of the inlet manifold (34), the outlet manifold (36), and the plurality of fluid passages (38) is formed as a recess formed in the housing (22).

12. The heat exchanger assembly of claim 11, wherein the inlet (30) is disposed below the outlet (32) such that during operation a flow direction of a refrigerant through the inlet manifold (34) and the outlet manifold (36) opposes gravity.

13. The heat exchanger assembly of any of claims 9 to 12, wherein the housing (22) further comprises a first housing portion (24) and a second housing portion (26) joined along corresponding mating surfaces.

14. The heat exchanger assembly of claim 13, wherein at least one of the first housing portion (24) and the second housing portion (26) is a plate.

## Patentansprüche

1. Wärmetauscherbaugruppe, umfassend:
einen Wärmetauscher (20), der ein Gehäuse (22) beinhaltet;
ein Leistungselektronikmodul (50), das an einer Fläche (52) des Gehäuses (22) des Wärmetauschers (20) montiert ist, wobei das Leistungselektronikmodul (50) an einer Kühlkörpergrenzfläche (56) thermisch an den Wärmetauscher (20) gekoppelt ist;
ein thermisches Grenzflächenmaterial (58), das zwischen der Kühlkörpergrenzfläche (56) und der Fläche (52) des Gehäuses (22) des Wärmetauschers (20) angeordnet ist; und
eine Dichtung (60), die zwischen der Kühlkörpergrenzfläche (56) und der Fläche (52) des Gehäuses (22) des Wärmetauschers (20) angeordnet ist;
wobei das Leistungselektronikmodul (50) an einer vertikal ausgerichteten Fläche (52) des Gehäuses (22) montiert ist;
wobei die Dichtung (60) mindestens einen Teil des thermischen Grenzflächenmaterials (58) umgibt; und
wobei die Dichtung (60) eine Grenze definiert, die die Bewegung des thermischen Grenzflächenmaterials (58) relativ zu der Kühlkörpergrenzfläche (56) und der Fläche (52) des Gehäuses (22) des Wärmetauschers (20) einschränkt;
**dadurch gekennzeichnet, dass**:
die Fläche (52) des Wärmetauschers (20) eine darin ausgebildete Dichtungsnut (62) aufweist, wobei die Dichtung (60) innerhalb der Dichtungsnut (62) angeordnet ist.

2. Wärmetauscherbaugruppe nach Anspruch 1, wobei sich die Dichtung (60) um mindestens einen Teil eines Umfangs der Kühlkörpergrenzfläche (56) erstreckt.

3. Wärmetauscherbaugruppe nach Anspruch 2, wobei sich die Dichtung (60) um den gesamten Umfang der Kühlkörpergrenzfläche (56) erstreckt.

4. Wärmetauscherbaugruppe nach einem der vorhergehenden Ansprüche, wobei die Dichtung (60) unter Ausbilden einer Abdichtung zwischen der Kühlkörpergrenzfläche (56) und der Fläche (52) des Gehäuses (22) des Wärmetauschers (20) zusammengedrückt wird.

5. Wärmetauscherbaugruppe nach einem der vorhergehenden Ansprüche, wobei sich nur ein Teil der Dichtung (20) über die Fläche (52) des Wärmetauschers (20) hinaus erstreckt.

6. Wärmetauscherbaugruppe nach einem der vorhergehenden Ansprüche, wobei die Dichtung (60) eine im Wesentlichen durchgehende, schlauchförmige Konfiguration aufweist.

7. Wärmetauscherbaugruppe nach einem der Ansprüche 1 bis 5, wobei die Dichtung (60) eine im Wesentlichen planare Konfiguration aufweist.

8. Wärmetauscherbaugruppe nach einem der vorhergehenden Ansprüche, wobei das thermische Grenzflächenmaterial (58) eine Wärmeleitpaste ist.

9. Wärmetauscherbaugruppe nach einem der vorhergehenden Ansprüche, wobei der Wärmetauscher (20) Folgendes umfasst:
das Gehäuse (22), wobei das Gehäuse (22) einen Einlass (30) und einen Auslass (32) aufweist;
einen Fluidkreislauf, der innerhalb des Gehäuses (22) angeordnet ist und sich zwischen dem Einlass (30) und dem Auslass (32) erstreckt; und
ein Fluid, das durch den Fluidkreislauf zirkuliert.

10. Wärmetauscherbaugruppe nach Anspruch 9, wobei der Fluidkreislauf ferner Folgendes umfasst:
eine Einlasssammelleitung(34);
eine Auslasssammelleitung (36); und
eine Vielzahl von Fluidkanälen (38), die die Einlasssammelleitung (34) und die Auslasssammelleitung (36) verbindet.

11. Wärmetauscherbaugruppe nach Anspruch 10, wobei mindestens eine der Einlasssammelleitung (34), der Auslasssammelleitung (36) und der Vielzahl von Fluidkanälen (38) als eine in dem Gehäuse (22) ausgebildete Aussparung ausgebildet ist.

12. Wärmetauscherbaugruppe nach Anspruch 11, wobei der Einlass (30) derart unterhalb des Auslasses (32) angeordnet ist, dass während des Betriebs eine Strömungsrichtung eines Kältemittels durch die Einlasssammelleitung (34) und die Auslasssammelleitung(36) entgegen der Schwerkraft verläuft.

13. Wärmetauscherbaugruppe nach einem der Ansprüche 9 bis 12, wobei das Gehäuse (22) ferner einen ersten Gehäuseteil (24) und einen zweiten Gehäuseteil (26) umfasst, die entlang entsprechender Gegenflächen verbunden sind.

14. Wärmetauscherbaugruppe nach Anspruch 13, bei der mindestens einer des ersten Gehäuseteils (24) und des zweiten Gehäuseteils (26) eine Platte ist.

## Revendications

1. Ensemble échangeur de chaleur, comprenant :
un échangeur de chaleur (20) comportant un boîtier (22) ;
un module électronique de puissance (50) monté sur une surface (52) du boîtier (22) de l'échangeur de chaleur (20), dans lequel le module électronique de puissance (50) est couplé thermiquement à l'échangeur de chaleur (20) au niveau d'une interface de dissipateur thermique (56) ;
un matériau d'interface thermique (58) disposé entre l'interface du dissipateur thermique (56) et la surface (52) du boîtier (22) de l'échangeur de chaleur (20) ; et
un joint (60) disposé entre l'interface du dissipateur thermique (56) et la surface (52) du boîtier (22) de l'échangeur de chaleur (20) ;
dans lequel le module électronique de puissance (50) est monté sur une surface (52) orientée verticalement du boîtier (22) ;
dans lequel le joint (60) entoure au moins une partie du matériau d'interface thermique (58) ; et
dans lequel le joint (60) définit une limite qui restreint le mouvement du matériau d'interface thermique (58) par rapport à l'interface du dissipateur thermique (56) et à la surface (52) du boîtier (22) de l'échangeur de chaleur (20) ;
**caractérisé en ce que** :
la surface (52) de l'échangeur de chaleur (20) présente une rainure de joint (62) formée à l'intérieur, le joint (60) étant disposé à l'intérieur de la rainure de joint (62).

2. Ensemble échangeur de chaleur selon la revendication 1, dans lequel le joint (60) se prolonge autour d'au moins une partie d'une périphérie de l'interface de dissipateur thermique (56).

3. Ensemble échangeur de chaleur selon la revendication 2, dans lequel le joint (60) se prolonge autour d'une périphérie entière de l'interface de dissipateur thermique (56).

4. Ensemble échangeur de chaleur selon une quelconque revendication précédente, dans lequel le joint (60) est comprimé pour former un joint d'étanchéité entre l'interface de dissipateur thermique (56) et la surface (52) du boîtier (22) de l'échangeur de chaleur (20).

5. Ensemble échangeur de chaleur selon une quelconque revendication précédente, dans lequel seule une partie du joint (20) se prolonge au-delà de la surface (52) de l'échangeur de chaleur (20).

6. Ensemble échangeur de chaleur selon une quelconque revendication précédente, dans lequel le joint (60) présente une configuration sensiblement continue en forme de tube.

7. Échangeur de chaleur selon l'une quelconque des revendications 1 à 5, dans lequel le joint (60) présente une configuration sensiblement plane.

8. Ensemble échangeur de chaleur selon une quelconque revendication précédente, dans lequel le matériau d'interface thermique (58) est de la graisse thermique.

9. Ensemble échangeur de chaleur selon une quelconque revendication précédente, dans lequel l'échangeur de chaleur (20) comprend :
le boîtier (22), dans lequel ledit boîtier (22) présente une entrée (30) et une sortie (32) formées à l'intérieur ;
un circuit de fluide disposé à l'intérieur du boîtier (22) et se prolongeant entre l'entrée (30) et la sortie (32) ; et
un fluide circulant dans le circuit de fluide.

10. Ensemble échangeur de chaleur selon la revendication 9, dans lequel le circuit de fluide comprend également :
un collecteur d'entrée (34) ;
un collecteur de sortie (36) ; et
une pluralité de passages de fluide (38) reliant le collecteur d'entrée (34) et le collecteur de sortie (36).

11. Ensemble échangeur de chaleur selon la revendication 10, dans lequel au moins l'un du collecteur d'entrée (34), du collecteur de sortie (36) et de la pluralité de passages de fluide (38) est formé sous la forme d'un évidement formé dans le boîtier (22).

12. Ensemble échangeur de chaleur selon la revendication 11, dans lequel l'entrée (30) est disposée en dessous de la sortie (32) de telle sorte que pendant le fonctionnement, une direction d'écoulement d'un réfrigérant à travers le collecteur d'entrée (34) et le collecteur de sortie (36) s'oppose à la gravité.

13. Ensemble échangeur de chaleur selon l'une quelconque des revendications 9 à 12, dans lequel le boîtier (22) comprend également une première partie de boîtier (24) et une seconde partie de boîtier (26) jointes le long de surfaces d'accouplement correspondantes.

14. Ensemble échangeur de chaleur selon la revendication 13, dans lequel au moins l'une de la première partie de boîtier (24) et de la seconde partie de boîtier (26) est une plaque.
